# FASCICULE DE BREVET EUROPEEN

(11) **EP 3 566 554 B1**
(45) Date de publication et mention de la délivrance du brevet: **17.04.2024**
(21) Numéro de dépôt: 18701515.1
(22) Date de dépôt: 03.01.2018
(51) Int. Cl.: H01G 2/06, H01G 4/228, H01G 4/40, H05K 1/14, H05K 1/02

(54) **MODULE ÉLECTRIQUE COMPORTANT DEUX SUBSTRATS PARALLÈLES ET UN CONDENSATEUR DE DÉCOUPLAGE**
ELEKTRISCHES MODUL MIT ZWEI PARALLELEN SUBSTRATEN UND EINEM ENTKOPPLUNGSKONDENSATOR
ELECTRIC MODULE COMPRISING TWO PARALLEL SUBSTRATES AND A DECOUPLING CAPACITOR

(30) Priorité: 06.01.2017 FR 1750131
(43) Date de publication de la demande: 13.11.2019
(73) Titulaire: Commissariat à l'Energie Atomique et aux Energies Alternatives, 75015 Paris (FR)
(72) Inventeur: THOLLIN, Benoît, 38330 Montbonnot Saint Martin (FR)
(74) Mandataire: Guérin, Jean-Philippe
(86) Numéro de dépôt international: PCT/FR2018/050015
(87) Numéro de publication internationale: WO 2018/127660

(56) Documents cités:
- US-A1- 2003 170 931
- US-A1- 2014 118 882
- US-A1- 2014 262 463
- US-A1- 2015 366 063
- US-B1- 6 418 029

## Description

L'invention concerne l'électronique de puissance, et en particulier la réalisation de circuits électroniques de puissance à architecture tridimensionnelle et comportant des composants montés en surface (CMS). En particulier, des composants CMS incluent en général des condensateurs de découplage présentant une première électrode au potentiel d'un premier substrat et une deuxième électrode au potentiel d'un deuxième substrat.

Dans l'exemple détaillé dans le document US20150296623, un condensateur a ses deux électrodes connectées électriquement à deux contacts électriques respectifs d'un même substrat. Le condensateur est positionné allongé, c'est-à-dire qu'un axe reliant ses deux électrodes est parallèle au substrat. La connexion électrique entre chaque électrode et son contact électrique respectif est réalisée par l'intermédiaire d'un cadre conducteur dont une première extrémité est soudée à un contact du substrat et dont une deuxième extrémité est soudée à une électrode du condensateur. L'utilisation de tels cadres métalliques permet de réduire les contraintes thermomécaniques entre le condensateur et le substrat, pouvant apparaître du fait des différences de coefficient de dilatation thermique entre le condensateur et le substrat.

Si on souhaitait créer une architecture tridimensionnelle à partir de ce document, un tel condensateur utilisé en condensateur de découplage serait ainsi fixé à un premier substrat par l'intermédiaire de deux cadres métalliques à deux contacts électriques de ce premier substrat. Un deuxième substrat serait positionné parallèle au premier substrat, de sorte que le condensateur serait interposé entre les premier et deuxième substrats.

Aucune solution satisfaisante n'est connue pour rapporter le potentiel du deuxième substrat vers une des électrodes du condensateur sans créer de court-circuit. Par ailleurs, une telle architecture s'avérerait relativement volumineuse, en particulier lorsque la différence de potentiel entre les substrats est importante, ce qui induirait une distance importante entre les substrats. La tenue en tension entre le deuxième substrat et l'électrode du condensateur au potentiel du premier substrat serait alors assurée par l'espacement entre cette électrode et le deuxième substrat.

Une solution a été proposée dans le document 'Realization and characterization of an IGBT Module Based on the Power Chip-on-Chip 3D Concept', rédigé par Ms Marchesini et alias, qui propose de monter un condensateur de découplage associé à un demi-pont, sur un troisième substrat. Le premier substrat comporte une diode et un transistor IGBT, le deuxième substrat comporte également une diode et un transistor IGBT. Ce troisième substrat est placé entre des premier et deuxième substrats et déborde latéralement. Le condensateur est placé sur le débordement du troisième substrat. Les deux faces du troisième substrat sont polarisées à ces potentiels différents, correspondant aux potentiels des premier et deuxième substrats.

Une telle architecture présente des inconvénients. En effet, l'interconnexion induit des inductances parasites de maille. Lorsque le condensateur de découplage est connecté à d'autres composants haute fréquence d'un des deux substrats, ces inductances de maille peuvent occasionner des limitations de performances du système électrique, notamment des pertes électriques considérables à haute fréquence. De plus, le maintien mécanique de l'espacement entre les deux substrats peut s'avérer délicat à réaliser.

Le document US6418029 décrit un module électrique tridimensionnel comprenant des premier et deuxième substrats parallèles avec des contacts électriques respectifs orientés vers l'autre substrat. Le module comprend un condensateur comprenant une première électrode connectée électriquement et solidaire du contact du premier substrat et une deuxième électrode connectée électriquement et solidaire du contact du deuxième substrat. Le condensateur présente une continuité de matière formée entre les premier et deuxième substrats à travers un corps isolant du condensateur.

Il existe un besoin pour améliorer le contact électrique entre les première et deuxième électrodes et leurs contacts électriques respectifs des premier et deuxième substrats. Il existe également un besoin d'améliorer la résistance en compression appliquée perpendiculairement entre les substrats.

Le document US2014262463 divulgue un condensateur prévu pour être encastré dans un circuit imprimé.

Le document US2015366063 divulgue la connexion de deux substrats parallèles avec un condensateur ayant des première et deuxième électrodes opposées selon une direction parallèle aux deux substrats.

L'invention vise à résoudre un ou plusieurs de ces inconvénients. L'invention porte ainsi sur un module électrique tridimensionnel, tel que défini dans la revendication 1.

L'invention porte également sur les variantes définies dans les revendications dépendantes. L'homme du métier comprendra que chacune des caractéristiques des variantes des revendications dépendantes peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe transversale schématique d'un exemple d'un module électrique tridimensionnel selon un mode de réalisation ;
- la figure 2 est un schéma électrique équivalent du module électrique de la figure 1 ;
- la figure 3 est une vue en coupe longitudinale d'un exemple de condensateur pour le mode de réalisation de la figure 1 ;
- la figure 4 est une vue en coupe transversale schématique d'un exemple d'un module électrique selon une variante ;
- la figure 5 est une vue en coupe transversale schématique d'un exemple d'un module électrique selon une autre variante.

L'invention propose de former une entretoise entre deux substrats d'un module électrique tridimensionnel (en particulier pour un module de puissance), par l'intermédiaire d'un condensateur de découplage. Ce condensateur de découplage comporte une première électrode connectée électriquement et solidaire d'un contact d'un premier substrat, et une deuxième électrode connectée électriquement et solidaire d'un contact du deuxième substrat.

Les connectiques d'un tel condensateur de découplage présentent ainsi des inductances propres (impactant les inductances de maille) plus réduites, favorisant le fonctionnement à haute fréquence du module électrique. Un tel condensateur de découplage participe également à la résistance mécanique du module électrique, en particulier sa résistance à une compression appliquée perpendiculairement aux deux substrats.

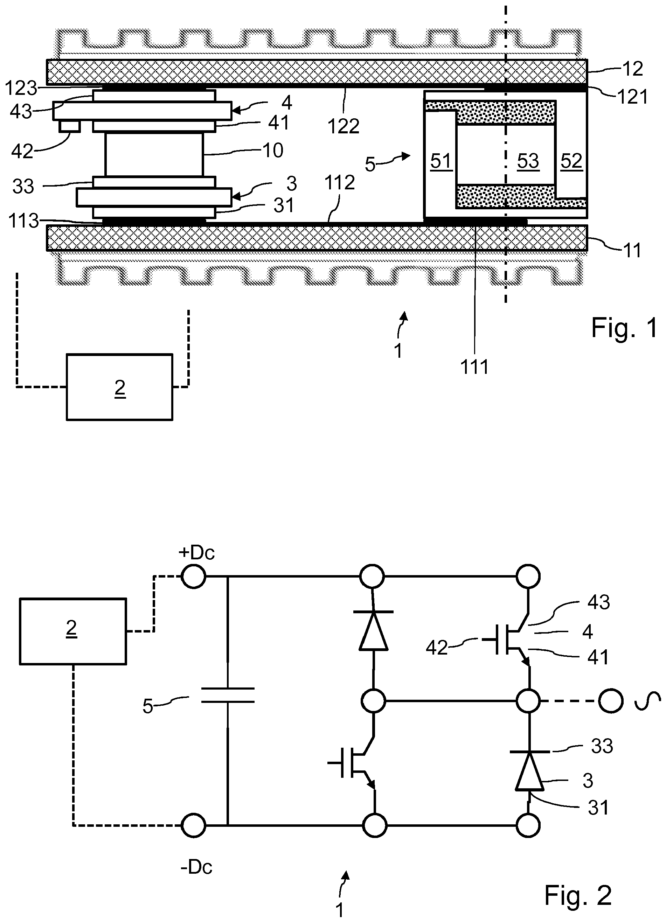

La figure 1 est une vue en coupe transversale d'un exemple d'un module électrique tridimensionnel 1 selon un mode de réalisation. Le module électrique 1 est ici illustré pour une application particulière à un onduleur. Le module électrique comprend les substrats 11 et 12 de structure connue en soi. Les substrats 11 et 12 sont sensiblement plans et positionnés parallèles l'un de l'autre. Le substrat 11 comporte une face supérieure orientée vers le substrat 12 et comportant un contact électrique 111 orienté vers ce substrat 12. Le substrat 12 comporte une face inférieure orientée vers le substrat 11 et comportant un contact électrique 121 orienté vers ce substrat 11. Les contacts 111 et 121 sont ici décalés selon une direction parallèle aux substrats 11 et 12. La direction normale aux substrats 11 et 12 est ici illustrée par la droite en tirets-points.

Le module électrique 1 comporte un condensateur 5 monté en surface, dont la structure sera davantage détaillée par la suite. Si la capacité du condensateur 5 est insuffisante, il peut être connecté à un autre condensateur déporté le cas échéant. Le condensateur 5 comporte une première électrode 51 et une deuxième électrode 52, situées à des extrémités axiales opposées de ce condensateur 5. Un corps 53, dont la partie externe est isolante, est disposé entre les électrodes 51 et 52. L'électrode 51 est connectée électriquement et est solidaire du contact 111 du substrat 11. L'électrode 52 est connectée électriquement et est solidaire du contact 121 du substrat 12. Ainsi, un potentiel d'alimentation du substrat 11 peut être appliqué directement sur l'électrode 51 sans nécessiter une éventuelle interconnexion électrique tridimensionnelle provenant du substrat 12. De même, un potentiel d'alimentation du substrat 12 peut être appliqué directement sur l'électrode 52 sans nécessiter une éventuelle interconnexion électrique tridimensionnelle provenant du substrat 11. L'inductance de maille du module électrique 1 peut ainsi être réduite. Les électrodes 51 et 52 peuvent être connectées électriquement et fixées respectivement aux contacts 111 et 121 par l'intermédiaire de soudures ou de brasures ou par frittage ou par collage conducteur. Par ailleurs, on maintient une distance optimale entre le potentiel du contact électrique 111 et l'électrode 52 d'une part, et le potentiel du contact électrique 121 et l'électrode 51 d'autre part, ce qui favorise une résistance à une tension de claquage : la tension de claquage du condensateur 5 dimensionne ainsi la tension de claquage du module électrique 1 (au moins dans la zone du condensateur).

Comme illustré à la figure 1, une continuité de matière est formée entre les substrats 11 et 12 selon un axe perpendiculaire à ces substrats 11 et 12, illustré par la ligne en tirets-points. En effet, la continuité de matière est ici formée entre les contacts électriques 111 et 121, par l'intermédiaire de l'électrode 51, du corps 53 et de l'électrode 52. Le condensateur 5 forme donc ici une entretoise entre les substrats 11 et 12, participant à la résistance en compression entre ces substrats 11 et 12 selon leur direction perpendiculaire. Le condensateur 5 est ici positionné parallèlement aux substrats 11 et 12, c'est-à-dire que ses électrodes 51 et 52 sont alignées perpendiculairement à l'axe en tirets-points.

Le condensateur 5 est ici un condensateur de découplage entre les substrats 11 et 12. Les électrodes 51 et 52 sont ainsi destinées à recevoir des potentiels d'alimentation différents appliqués au substrat 11 et 12 respectivement. En particulier, le module électrique 1 est associé à un circuit d'alimentation 2, configuré pour appliquer des potentiels distincts sur les contacts électriques 111 et 121 des substrats 11 et 12 respectivement.

Le substrat 11 comporte en outre un autre contact électrique 113 décalé latéralement par rapport au contact 111. Les contacts électriques 111 et 113 sont connectés électriquement par l'intermédiaire d'une piste conductrice 112. Un composant électronique 3 est ici connecté électriquement au contact électrique 113. Le composant électronique 3 est en l'occurrence une diode.

Le substrat 12 comporte en outre un autre contact électrique 123 décalé latéralement par rapport au contact 121. Les contacts électriques 121 et 123 sont connectés électriquement par l'intermédiaire d'une piste conductrice 122. Un composant électronique 4 est ici connecté électriquement au contact électrique 123. Le composant électronique 4 est en l'occurrence un transistor IGBT. Les composants 3 et 4 sont par exemple destinés à la formation d'un circuit en demi-pont, comme l'exemple illustré schématiquement à la figure 2.

Les contacts 113 et 123 et les composants 3 et 4 sont alignés selon un axe perpendiculaire aux substrats 11 et 12.

L'anode 31 de la diode 3 est connectée électriquement et fixée au contact électrique 113. Ce contact électrique 113 est porté à un potentiel d'alimentation du substrat 11. La diode 3 comporte une cathode 33. La cathode 33 est connectée électriquement à un contact d'une sortie de tension alternative 10. Le contact 10 est interposé entre la diode 3 et le transistor IGBT 4.

Le drain 43 du transistor IGBT 4 est connecté électriquement et fixé au contact électrique 123. Ce contact électrique 123 est porté un potentiel d'alimentation du substrat 12. Le transistor IGBT 4 comporte une grille de commande 42 commandée de façon connue en soi par un circuit de commande non illustré. Le transistor 4 comporte une source 41. La source 41 est connectée électriquement au contact de sortie de tension alternative 10.

Le schéma électrique équivalent du module électrique 1 complété pour former un demi-pont est illustré à la figure 2. Le circuit d'alimentation 2 applique une tension +Dc sur le drain 43 et sur l'électrode 52, et une tension -De sur la source 31 et sur l'électrode 51. Une telle application d'onduleur s'avère en pratique particulièrement compacte et optimisée pour limiter les inductances de maille parasites. L'invention s'avère ainsi particulièrement avantageuse pour des composants de commutation à haute fréquence (par exemple typiquement au moins égale à 100kHz) et/ou à haute tension (par exemple typiquement au moins égale à 100V), domaines d'application de prédilection pour des IGBT, des MOSFET ou des transistors à haute mobilité électronique. L'invention s'avère également avantageuse à basse fréquence, en réduisant les surtensions et les ondulations.

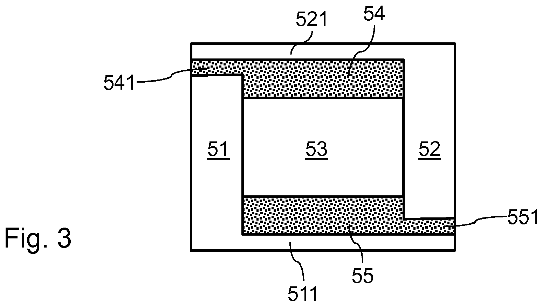

La figure 3 est une vue en coupe longitudinale d'un condensateur 5 pour la formation d'une d'un module électrique tridimensionnel 1 tel qu'illustré à la figure 1. Le condensateur 5 est ici configuré pour être positionné parallèlement aux substrats 11 et 12. L'encombrement d'un condensateur 5 étant généralement plus important suivant sa direction axiale que suivant sa direction transversale, un tel positionnement permet de réduire l'encombrement du module électrique 1 selon une direction perpendiculaire aux substrats 11 et 12, par réduction de la distance entre les substrats 11 et 12.

Par exemple, pour un condensateur 5 présentant une tension de claquage de 1000 V, on peut envisager qu'il présente une longueur de 2,1 mm entre ces électrodes 51 et 52, et une hauteur d'électrode de 1,4 mm. Même en interposant du matériau diélectrique entre les électrodes du condensateur 5 et les substrats 11 et 12, une telle configuration permet de réduire l'encombrement du module électrique 1 selon une direction perpendiculaire aux substrats 11 et 12.

Le condensateur 5 comporte une première électrode 51 et une deuxième électrode 52. L'électrode 51 comporte une extrémité axiale, et un prolongement latéral 511. L'électrode 52 comporte une extrémité axiale, et un prolongement latéral 521. Les extrémités axiales respectives des électrodes 51 et 52 sont positionnées axialement de part et d'autre d'un corps 53, dont la surface externe au moins est isolante. Les prolongements latéraux 511 et 521 s'étendent latéralement de part et d'autre le long du corps 53. Dans cet exemple, le prolongement latéral 511 s'étend jusque sur le côté de l'électrode 52. Dans cet exemple, le prolongement latéral 521 s'étend jusque sur le côté de l'électrode 51. La connexion électrique et la fixation de l'électrode 51 à un contact conducteur du substrat 11 est destinée à être réalisée par l'intermédiaire du prolongement latéral 511. La connexion électrique et la fixation de l'électrode 52 à un contact conducteur du substrat 12 est destinée à être réalisée par l'intermédiaire du prolongement latéral 521.

Le condensateur 5 comprend en outre un matériau diélectrique 54 interposé entre le corps 53 et le prolongement latéral 521. Le matériau diélectrique 54 comporte également un prolongement 541 interposé entre le prolongement latéral 521 et l'électrode 51. Le prolongement 541 permet donc d'isoler électriquement l'électrode 51 par rapport au prolongement latéral 521 et par rapport au substrat 12.

Le condensateur 5 comprend en outre un matériau diélectrique 55 interposé entre le corps 53 et le prolongement latéral 511. Le matériau diélectrique 55 comporte également un prolongement 551 interposé entre le prolongement latéral 511 et l'électrode 52. Le prolongement 551 permet donc d'isoler électriquement l'électrode 52 par rapport au prolongement latéral 511 et par rapport au substrat 11.

Un tel condensateur 5 permet d'améliorer le contact électrique entre les électrodes 51 et 52 et leurs contacts électriques respectifs des substrats 11 et 12, et permet d'améliorer la résistance en compression appliquée perpendiculairement entre les substrats 11 et 12. En outre, un tel condensateur 5 est approprié pour réaliser le dépôt des matériaux diélectriques 54 et 55 par des procédés tels que le PECVD lors de sa fabrication. Les matériaux diélectriques ainsi déposés peuvent présenter une très grande rigidité diélectrique, permettant de réduire l'épaisseur des matériaux diélectriques 54 et 55. Par ailleurs, en intégrant de tels matériaux diélectriques 54 et 55 dès le procédé de fabrication du condensateur 5, on contrôle particulièrement bien la structure et la géométrie de ces matériaux diélectriques 54 et 55, et donc la tension de claquage entre les électrodes 51 et 52. Par ailleurs, du fait de la géométrie des électrodes 51 et 52, un tel condensateur 5 inclut intrinsèquement des cadres métalliques intégrés à ses électrodes 51 et 52. Les électrodes 51 et 52 peuvent être au moins partiellement formées par une métallisation des matériaux diélectriques 54 et 55.

Dans l'exemple de la figure 1 :
- le prolongement latéral 511 est soudé au contact 111 du substrat 11 ;
- le prolongement latéral 521 est soudé au contact 121 du substrat 12.

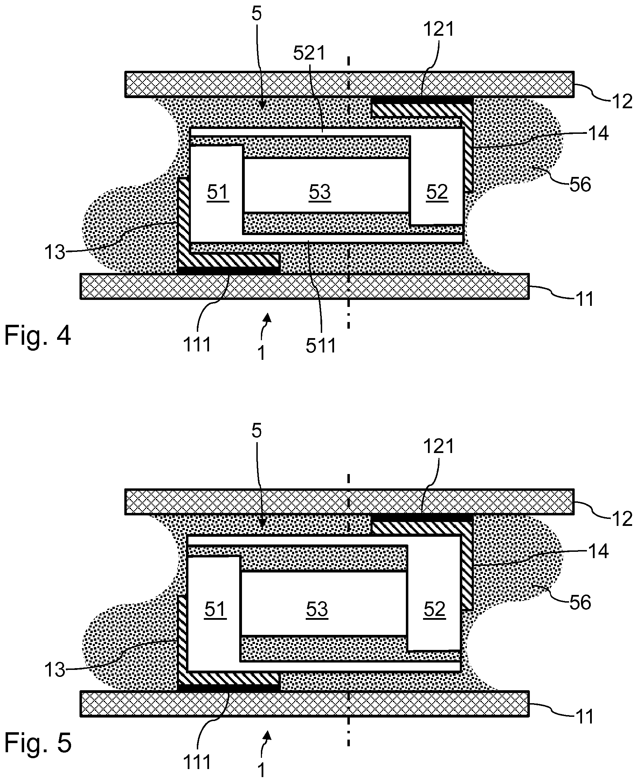

La figure 4 est une vue en coupe transversale d'un exemple d'un module électrique tridimensionnel 1 selon une variante. Même si les électrodes 51 et 52 du condensateur 5 de la figure 3 font office de cadres métalliques, on peut également envisager de connecter électriquement et solidariser le condensateur 5 aux substrats 11 et 12 par l'intermédiaire de cadres métalliques additionnels.

L'électrode 51 est ici connectée électriquement et est solidarisée au contact 111 du substrat 11, par l'intermédiaire d'un cadre métallique 13. Le cadre métallique 13 peut être soudé d'une part au contact 111, et d'autre part à une face d'extrémité de l'électrode 51. L'électrode 52 est connectée électriquement et est solidarisée au contact 121 du substrat 12, par l'intermédiaire d'un cadre métallique 14. Le cadre métallique 14 peut être soudé ou brasé d'une part au contact 121, et d'autre part à une face d'extrémité de l'électrode 52. L'utilisation de cadres métalliques 13 et 14 permet d'absorber des déformations éventuelles liées à des différences de coefficients de dilatation thermique ou à des dispersions géométriques.

Un matériau diélectrique 56 est positionné au moins sur le côté des contacts électriques 111 et 121, afin de s'interposer entre l'électrode 51 et le substrat 12 d'une part, et entre l'électrode 52 et le substrat 11 d'autre part. Le matériau diélectrique 56 est solide, pour assurer un maintien mécanique transversal. Par ailleurs, le matériau diélectrique 56 est également interposé entre une face latérale de l'électrode 51 et une paroi du cadre métallique 13 parallèle au substrat 11. Ainsi, l'électrode 51 est fixée à un montant du cadre 13, s'étendant selon la normale au substrat 11 mais est espacée d'un montant du cadre 13 parallèle à ce substrat 11. Par ailleurs, le matériau diélectrique 56 est également interposé entre une face latérale de l'électrode 52 et une paroi du cadre métallique 14 parallèle au substrat 12. Ainsi, l'électrode 52 est fixée à un montant du cadre 14, s'étendant selon la normale au substrat 12 mais est espacée d'un montant du cadre 14 parallèle à ce substrat 12.

Une continuité de matière à travers le condensateur 5 est ainsi obtenue perpendiculairement au substrat 11 et 12, par exemple à travers :
- un axe traversant du matériau diélectrique 56, le prolongement 521, le matériau diélectrique 54, le corps 53, le matériau diélectrique 55, le prolongement 511 puis du matériau diélectrique 56 ;
- un axe traversant du matériau diélectrique 56, le prolongement 521, le matériau diélectrique 54, l'électrode 51 et une paroi du cadre 13 ;
- un axe traversant une paroi du cadre 14, l'électrode 52, le matériau diélectrique 55, le prolongement 511 puis du matériau diélectrique 56.

Le matériau diélectrique 56 est par exemple un matériau diélectrique de remplissage entre les substrats 11 et 12.

Le condensateur 5 forme donc ici une entretoise entre les substrats 11 et 12, participant à la résistance en compression entre ces substrats 11 et 12 selon leur direction perpendiculaire.

Avec un gel diélectrique en silicone d'encapsulation tel que celui commercialisé par la société Quantum silicones sous la référence commerciale Qsil550, une épaisseur de 57µm est suffisante entre un substrat et une électrode du condensateur 5 pour résister à une tension de claquage de 1000V. On peut choisir un matériau diélectrique de remplissage soit rigide à température ambiante (pour garantir une tenue mécanique des matériaux diélectriques 54 et 55), soit compressible si l'on souhaite conférer une certaine flexibilité à la structure.

On peut citer un certain nombre de matériaux diélectriques et leurs propriétés en vue de réaliser les matériaux diélectriques 54 et 55 (ou 56 pour la variante précédente). Le choix des matériaux pourra également être réalisé en fonction du comportement en température du matériau, en fonction des applications visées pour le condensateur 5.

| | Matériaux | Rigidité diélectrique kV/mm | Distance pour tension claquage de 1000V |
|---|---|---|---|
| Gels diélectriques | Qsil 550 | 17,5 | 57,1µm |
| | Quantum silicones | | |
| | Qsil 1000 | 18 | 55,6µm |
| | Quantum silicones | | |
| | Duraseal 1533 | 19,7 | 50,8µm |
| | Cotronics Corp | | |
| | Sylgard 527 | 15 | 66,7µm |
| | Dow Corning | | |
| | Nusil R-21060 | 20 | 50µm |
| | Nusil | | |
| | Qsil 550 | 17,5 | 57,1µm |
| | Quantum silicones | | |
| Céramiques | AIN | 15 | 66,7µm |
| | BeO | 12 | 83,3µm |
| | Si₃N₄ | 14,8 | 67,6µm |
| | Al₂O₃ | 13 | 76,9µm |
| Divers | Résine Epoxyde | 20 | 50µm |
| | Duralco 4703 | | |
| | Polyimide | 28 | 35,7µm |
| | SiO₂-PECVD | 600 | 1,7µm |
| | Si₃N₄-PECVD | 1000 | 1µm |

La figure 5 est une vue en coupe transversale d'un exemple d'un module électrique tridimensionnel 1 selon une autre variante. Cette variante diffère de celle de la figure 4 uniquement par les caractéristiques suivantes :
- l'électrode 51 est plaquée contre la paroi du cadre métallique 13 parallèle au substrat 11 ;
- aucun matériau diélectrique 56 n'est interposé entre l'électrode 51 et le cadre métallique 13 ;
- l'électrode 52 est plaquée contre la paroi du cadre métallique 14 parallèle au substrat 12 ;
- aucun matériau diélectrique 56 n'est interposé entre l'électrode 52 et le cadre métallique 14.

## Revendications

1. Module électrique tridimensionnel (1), comprenant des premier et deuxième substrats parallèles (11,12), chacun desdits premier et deuxième substrats comportant un contact électrique (111,121) orienté vers l'autre desdits premier et deuxième substrats ;
le module comprenant en outre un condensateur (5) comprenant :
- une première électrode (51) connectée électriquement et solidaire du contact (111) du premier substrat (11), et
- une deuxième électrode (52) connectée électriquement et solidaire du contact (121) du deuxième substrat (12) ;
- une continuité de matière étant formée entre les premier et deuxième substrats, perpendiculairement aux premier et deuxième substrats, et à travers ledit condensateur (5) ;
- un corps isolant (53) disposé entre les première et deuxième électrodes (51,52), ladite continuité de matière étant formée à travers ledit corps isolant (53) ;
- les contacts (111,121) des premier et deuxième substrats (11,12) étant décalés selon une direction parallèle aux premier et deuxième substrats, la première électrode (51) comportant une extrémité axiale et la deuxième électrode (52) comportant une extrémité axiale, ledit corps isolant (53) étant disposé entre les extrémités axiales des première et deuxième électrodes, lesdites extrémités axiales des première et deuxième électrodes étant opposées selon une direction parallèle auxdits premier et deuxième substrats, la première électrode (51) comportant un prolongement latéral (511) s'étendant latéralement le long du corps (53) isolant sur le côté du premier contact et s'étendant vers l'extrémité axiale de la deuxième électrode, un matériau diélectrique (551) étant interposé entre la deuxième électrode et le prolongement latéral de la première électrode, la deuxième électrode (52) comportant un prolongement latéral (521) s'étendant latéralement le long du corps (53) isolant sur le côté du deuxième contact et s'étendant vers l'extrémité axiale de la première électrode, un matériau diélectrique (541) étant interposé entre la première électrode et le prolongement latéral de la deuxième électrode, le condensateur comprenant un matériau diélectrique (55) interposé entre le corps isolant et le prolongement latéral de la première électrode et comprenant un matériau diélectrique (54) interposé entre le corps isolant et le prolongement latéral de la deuxième électrode.

2. Module électrique tridimensionnel (1) selon la revendication 1, comprenant un composant électronique (3) et dans lequel le premier substrat (11) comporte une piste conductrice (112) raccordant électriquement le composant électronique et la première électrode (51) du condensateur.

3. Module électrique tridimensionnel (1) selon la revendication 1 ou 2, comprenant en outre un circuit d'alimentation (2) configuré pour appliquer des potentiels distincts (+Dc, -Dc) sur les contacts électriques (111,121) des premier et deuxième substrats (11,12).

4. Module électrique tridimensionnel (1) selon l'une quelconque des revendications précédentes, dans lequel les contacts (111,121) des premier et deuxième substrats (11,12) sont décalés selon une direction parallèle aux premier et deuxième substrats, un matériau diélectrique (56) étant interposé sur le côté du contact (111) du premier substrat, entre ladite deuxième électrode (52) et ledit premier substrat (11).

5. Module électrique tridimensionnel (1) selon la revendication 4, comprenant en outre un premier cadre métallique (13) soudé d'une part au contact (111) du premier substrat (11) et d'autre part à la première électrode (51), et un deuxième cadre métallique (14) soudé d'une part au contact (121) du deuxième substrat (12) et d'autre part à la deuxième électrode (52).

6. Module électrique tridimensionnel (1) selon la revendication 5, dans lequel une partie dudit matériau diélectrique (56) est également interposée entre le contact (111) du premier substrat (11) et la première électrode (51).

7. Module électrique tridimensionnel (1) selon l'une quelconque des revendications précédentes, dans lequel :
- la première électrode (51) inclut une couche métallique formée sur ledit diélectrique (55) interposé entre le corps et le prolongement latéral de la première électrode ;
- la deuxième électrode (52) inclut une couche métallique formée sur ledit matériau diélectrique (54) interposé entre le corps et le prolongement latéral de la deuxième électrode.

## Patentansprüche

1. Dreidimensionales elektrisches Modul (1), das ein erstes und ein zweites Substrat (11, 12) beinhaltet, die zueinander parallel sind, wobei jedes von dem ersten und dem zweiten Substrat einen elektrischen Kontakt (111, 121) umfasst, der zu dem anderen von dem ersten und dem zweiten Substrat gerichtet ist;
wobei das Modul ferner einen Kondensator (5), beinhaltet, der Folgendes beinhaltet:
- eine erste Elektrode (51), die mit dem Kontakt (111) des ersten Substrats (11) elektrisch und fest verbunden ist, und
- eine zweite Elektrode (52), die mit dem Kontakt (121) des zweiten Substrats (12) elektrisch und fest verbunden ist;
- wobei zwischen dem ersten und dem zweiten Substrat senkrecht zu dem ersten und dem zweiten Substrat und durch den Kondensator (5) hindurch eine stoffschlüssige Verbindung gebildet ist;
- einen Isolationskörper (53), der zwischen der ersten und der zweiten Elektrode (51, 52) angeordnet ist, wobei die stoffschlüssige Verbindung durch den Isolationskörper (53) hindurch gebildet ist;
- wobei die Kontakte (111, 112) des ersten und des zweiten Substrats (11, 12) gemäß einer zu dem ersten und dem zweiten Substrat parallelen Richtung versetzt sind, wobei die erste Elektrode (51) ein axiales Ende umfasst und die zweite Elektrode (52) ein axiales Ende umfasst, wobei der Isolationskörper (53) zwischen den axialen Enden der ersten und der zweiten Elektrode angeordnet ist, wobei sich die axialen Enden der ersten und der zweiten Elektrode gemäß einer zu dem ersten und dem zweiten Substrat parallelen Richtung gegenüberliegen, wobei die erste Elektrode (51) eine laterale Verlängerung (511) umfasst, die sich auf der Seite des ersten Kontakts lateral entlang des Isolationskörpers (53) erstreckt und sich zu dem axialen Ende der zweiten Elektrode erstreckt, wobei zwischen der zweiten Elektrode und der lateralen Verlängerung der ersten Elektrode ein dielektrisches Material (551) eingefügt ist, wobei die zweite Elektrode (52) eine laterale Verlängerung (521) umfasst, die sich auf der Seite des zweiten Kontakts lateral entlang des Isolationskörpers (53) erstreckt und sich zu dem axialen Ende der ersten Elektrode erstreckt, wobei zwischen der ersten Elektrode und der lateralen Verlängerung der zweiten Elektrode ein dielektrisches Material (541) eingefügt ist, wobei der Kondensator ein dielektrisches Material (55) beinhaltet, das zwischen dem Isolationskörper und der lateralen Verlängerung der ersten Elektrode eingefügt ist, und ein dielektrisches Material (54) beinhaltet, das zwischen dem Isolationskörper und der lateralen Verlängerung der zweiten Elektrode eingefügt ist.

2. Dreidimensionales elektrisches Modul (1) nach Anspruch 1, das eine elektronische Komponente (3) beinhaltet, und wobei das erste Substrat (11) eine Leiterbahn (112) umfasst, die die elektronische Komponente und die erste Elektrode (51) des Kondensators elektrisch verbindet.

3. Dreidimensionales elektrisches Modul (1) nach Anspruch 1 oder 2, das ferner eine Versorgungsschaltung (2) beinhaltet, die dazu konfiguriert ist, unterschiedliche Potenziale (+Dc, -Dc) an die elektrischen Kontakte (111, 121) des ersten und des zweiten Substrats (11, 12) anzulegen.

4. Dreidimensionales elektrisches Modul (1) nach einem beliebigen der vorhergehenden Ansprüche, wobei die Kontakte (111, 121) des ersten und des zweiten Substrats (11, 12) gemäß einer zu dem ersten und dem zweiten Substrat parallelen Richtung versetzt sind, wobei auf der Seite des Kontakts (111) des ersten Substrats zwischen der zweiten Elektrode (52) und dem ersten Substrat (11) ein dielektrisches Material (56) eingefügt ist.

5. Dreidimensionales elektrisches Modul (1) nach Anspruch 4, das ferner einen ersten Metallrahmen (13), der einerseits an den Kontakt (111) des ersten Substrats (11) und andererseits an die erste Elektrode (51) geschweißt ist, und einen zweiten Metallrahmen (14), der einerseits an den Kontakt (121) des zweiten Substrats (12) und andererseits an die zweite Elektrode (52) geschweißt ist, beinhaltet.

6. Dreidimensionales elektrisches Modul (1) nach Anspruch 5, wobei ein Teil des dielektrischen Materials (56) auch zwischen dem Kontakt (111) des ersten Substrats (11) und der ersten Elektrode (51) eingefügt ist.

7. Dreidimensionales elektrisches Modul (1) nach einem beliebigen der vorhergehenden Ansprüche, wobei:
- die erste Elektrode (51) eine Metallschicht umfasst, die auf dem Dielektrikum (55) gebildet ist, das zwischen dem Körper und der lateralen Verlängerung der ersten Elektrode eingefügt ist;
- die zweite Elektrode (52) eine Metallschicht umfasst, die auf dem dielektrischen Material (54) gebildet ist, das zwischen dem Körper und der lateralen Verlängerung der zweiten Elektrode eingefügt ist.

## Claims

1. Three-dimensional electrical module (1), comprising first and second parallel substrates (11, 12), each of said first and second substrates comprising an electrical contact (111, 121) oriented towards the other of said first and second substrates;
the module furthermore comprising a capacitor (5) comprising:
- a first electrode (51) electrically connected and securely fastened to the contact (111) of the first substrate (11), and
- a second electrode (52) electrically connected and securely fastened to the contact (121) of the second substrate (12);
- a continuity of material being formed between the first and second substrates, perpendicular to the first and second substrates, and through said capacitor (5);
- an insulating body (53) placed between the first and second electrodes (51, 52), said continuity of material being formed through said insulating body (53),
- the contacts (111, 121) of the first and second substrates (11, 12) being offset in a direction parallel to the first and second substrates, the first electrode (51) comprising an axial end and the second electrode (52) comprising an axial end, said insulating body (53) being placed between the axial ends of the first and second electrodes, said axial ends of the first and second electrodes being opposite in a direction parallel to said first and second substrates, the first electrode (51) comprising a lateral extension (511) that extends laterally along the insulating body (53) on the side of the first contact and that extends towards the axial end of the second electrode, a dielectric material (551) being interposed between the second electrode and the lateral extension of the first electrode, the second electrode (52) comprising a lateral extension (521) that extends laterally along the insulating body (53) on the side of the second contact and that extends towards the axial end of the first electrode, a dielectric material (541) being interposed between the first electrode and the lateral extension of the second electrode, the capacitor comprising a dielectric material (55) interposed between the insulating body and the lateral extension of the first electrode and comprising a dielectric material (54) interposed between the insulating body and the lateral extension of the second electrode.

2. Three-dimensional electrical module (1) according to Claim 1, comprising an electronic component (3) and wherein the first substrate (11) comprises a conductive track (112) electrically connecting the electronic component and the first electrode (51) of the capacitor.

3. Three-dimensional electrical module (1) according to Claim 1 or 2, furthermore comprising a supply circuit (2) configured to apply distinct potentials (+Dc, -Dc) to the electrical contacts (111, 121) of the first and second substrates (11, 12).

4. Three-dimensional electrical module (1) according to any one of the preceding claims, wherein the contacts (111, 121) of the first and second substrates (11, 12) are offset in a direction parallel to the first and second substrates, a dielectric material (56) being interposed, on the side of the contact (111) of the first substrate, between said second electrode (52) and at said first substrate (11).

5. Three-dimensional electrical module (1) according to Claim 4, furthermore comprising a first metal frame (13) soldered on the one hand to the contact (111) of the first substrate (11) and on the other hand to the first electrode (51), and a second metal frame (14) soldered on the one hand to the contact (121) of the second substrate (12) and on the other hand to the second electrode (52).

6. Three-dimensional electrical module (1) according to Claim 5, wherein one portion of said dielectric material (56) is also interposed between the contact (111) of the first substrate (11) and the first electrode (51).

7. Three-dimensional electrical module (1) according to any one of the preceding claims, wherein:
- the first electrode (51) includes a metal layer formed on said dielectric (55) interposed between the body and the lateral extension of the first electrode;
- the second electrode (52) includes a metal layer formed on said dielectric material (54) interposed between the body and the lateral extension of the second electrode.
